# EUROPÄISCHE PATENTSCHRIFT

(11) **EP 1 673 866 B1**
(45) Veröffentlichungstag und Bekanntmachung des Hinweises auf die Patenterteilung: **13.02.2013**
(21) Anmeldenummer: 04764078.4
(22) Anmeldetag: 13.08.2004
(51) Int. Cl.: H03K 17/95

(54) **SICHERHEITSSCHALTER, INSBESONDERE NOT-AUS-SCHALTER, ZUM SICHEREN ABSCHALTEN EINES GEFAHRBRINGENDEN GERÄTES**
SAFETY SWITCH, PARTICULARLY AN EMERGENCY STOP SWITCH FOR RELIABLY SWITCHING OFF A DANGEROUS DEVICE
COMMUTATEUR DE PROTECTION, NOTAMMENT COMMUTATEUR D'ARRET D'URGENCE, POUR DECONNECTER UN DISPOSITIF DANGEREUX

(30) Priorität: 14.10.2003 DE 10348884
(43) Veröffentlichungstag der Anmeldung: 28.06.2006
(73) Patentinhaber: Pilz GmbH & Co. KG, 73760 Ostfildern (DE)
(72) Erfinder: PULLMANN, Jürgen, 73061 Ebersbach (DE); ZINSER, Christoph, 72649 Wolfschlugen (DE); STARK, Klaus, 73235 Weilheim/Teck (DE)
(74) Vertreter: Duhme, Torsten
(86) Internationale Anmeldenummer: PCT/EP2004/009081
(87) Internationale Veröffentlichungsnummer: WO 2005/048453

(56) Entgegenhaltungen:
- EP-A- 0 968 567
- DE-A- 3 440 027
- DE-A- 4 233 922
- DE-C- 10 000 799

## Beschreibung

Die vorliegende Erfindung betrifft einen Sicherheitsschalter, insbesondere Not-Aus-Schalter, zum sicheren Abschalten eines gefahrbringenden Gerätes, mit einem mechanisch betätigten Stellelement, das zwischen einer ersten und zumindest einer zweiten Position bewegbar ist, und einem Detektorelement zum Detektieren des Stellelements in zumindest einer der genannten Positionen, wobei das Detektorelement einen Transponder mit einer individuellen Transponderkennung und eine zum Auslesen der Transponderkennung ausgebildete Leseeinheit beinhaltet, und wobei der Transponder und die Leseeinheit so zueinander angeordnet sind, dass die Leseeinheit den Transponder in der ersten Position des Stellelements, nicht jedoch in dessen zweiter Position auslesen kann.

Ein solcher Sicherheitsschalter ist beispielsweise aus WO 98/43351 bekannt.

Bei automatisiert arbeitenden Anlagen werden häufig einteilige mechanische Sicherheitsschalter verwendet, um die Anlage bei Auftreten einer Gefahrensituation in einen sicheren zustand zu bringen. Dies kann beispielsweise ein sofortiges Abschalten der Anlage beim manuellen Betätigen eines Not-Aus-Schalters sein. Abhängig vom Anwendungsfall kann jedoch auch eine sichere Ruheposition eingenommen oder eine Teilfunktion der Anlage blockiert werden. Typische Beispiele für gattungsgemäße Sicherheitsschalter sind neben manuell betätigten Not-Aus-Schaltern ("Pilz-Taster") manuelle ZustimmsChalter sowie Positions- und Endschalter, die über Hebel, Rollen, Scharniere oder dergleichen mechanisch betätigt werden. Beispiele derartiger Sicherheitsschalter sind aus DE 199 02 910 A1, DE 199 02 919 A1, DE 199 37 947 A1 oder DE 34 30 090 A1 bekannt.

All diesen sicherheitsschaltern ist es gemeinsam, dass sie ein mechanisch betätigtes Stellelement besitzen, dessen jeweilige Position mit Hilfe eines Detektorelements überwacht wird. In der Praxis sind die Detektorelemente bis heute üblicherweise als elektromechanische Schaltelemente ausgebildet, deren Kontakte durch das bewegliche Stellelement geöffnet oder geschlossen werden. Für Sicherheitsschalter werden dabei üblicherweise sogenannte zwangsöffnende Anordnungen verwendet, die ein Öffnen des Sicherheitsschalters auch bei einer Funktionsstörung im Sicherheitsschalter selbst gewährleisten, wie etwa bei (einem Hängenbleiben der Kontakte in der schließposition. Diese Sicherheitsschalter, insbesondere Not-Aus-Schalter, können aufgrund der langjährigen Erfahrung und aufgrund der hohen Stückzahlen recht kostengünstig und zuverlässig produziert werden.

In der Praxis ist das "Vertrauen" in die Funktionssicherheit solcher Sicherheitsschalter jedoch trotzdem begrenzt. So gibt es beispielsweise bei Produktionsanlagen für die Automobilindustrie die Forderung, dass sämtliche Not-Aus-Schalter zumindest ein- oder zweimal im Jahr manuell betätigt werden müssen, um deren Funktionssicherheit zu überprüfen. Es ist leicht nachvollziehbar, dass diese Funktionsüberprüfungen bei weiträumigen, großen Anlagen mit zahlreichen Not-Aus-Schaltern einige Zeit und damit einigen Aufwand in Anspruch nehmen. Zu den an sich geringen Herstellungskosten für einen Not-Aus-Schalter kommen daher über die Lebensdauer der Anlage, in der der Not-Aus-Schalter eingesetzt wird, Betriebskosten für die regelmäßige Funktionsüberprüfung.

Aus der DE 199 09 968 A1 ist ein sicherheitsschalter für elektrisch gesteuerte Maschinen bekannt, bei dem die Position des beweglichen Stellelements mit Hilfe von mehreren Gabellichtschranken ausgewertet werden soll. Alternativ werden ohne nähere Erläuterung induktive, kapazitive oder drucksensitive, beispielsweise piezoelektrische, Positionserfassungsvorrichtungen vorgeschlagen. Ziel dieser Maßnahmen ist es, eine aufwendige Mechanik zur Verhinderung von unerlaubten Schaltfolgen zu vermeiden und dabei trotzdem eine hohe Funktionssicherheit zu erreichen.

Aus der DE 100 23 199 A1 ist ein Sicherheitsschalter für elektrische Maschinen bekannt, der einen Kraft- oder Drucksensor aufweist, so dass zwischen einem gewollten Betätigungszustand und einem Panikzustand unterschieden werden kann.

Aus DE 100 37 003 A1 ist darüber hinaus ein Schlüsselschalter bekannt, der zum Prüfen einer Eingriffsberechtigung in rechnergestützte Steuereinrichtungen von Maschinen, Anlagen oder dergleichen vorgesehen ist. Statt eines mechanischen Schlüssels ist dabei die Verwendung eines Transponders vorgesehen, um die Eingriffsberechtigung festzustellen.

Der zuletzt genannte Schlüsselschalter ist außerdem auch in einem Buch mit dem Titel "Sicherheitsschaltgeräte" gezeigt, erschienen im Verlag Moderne Industrie als Band 232 der Reihe "Bibliothek der Technik", ISBN 3-478-93234-3. Als genereller Ausblick auf die technische Entwicklung auf diesem Gebiet wird hier ferner die Idee erwähnt, einen Sender in einen Zustimmschalter zu integrieren, der bei Betätigung einen eindeutigen Code per Datenfunk an einen zugeordneten Empfänger überträgt, wodurch das bislang oft hinderliche Kabel bei Zustimmschaltern überflüssig werden soll.

Aus DE 100 00 799 C1, EP 0 229 247 A2 und aus der eingangs genannten WO 98/43351 sind ferner berührungslos arbeitende (per se also zweiteilige, nicht mechanisch betätigte) Signalgeber bekannt, die auch nach dem Transponderprinzip arbeiten. Diese berührungslosen Signalgeber sollen unter anderem bei der Überwachung von Schutztüren eingesetzt werden.

Schließlich ist aus EP 0 099 278 A1 ein einteiliger, mechanisch betätigter Schalter bekannt, der wasserdicht ausgeführt ist. Das stellelement dieses Schalters besitzt metallische Abschnitte, die in einem gegen das Innere des Schaltergehäuses abgedichteten Ringspalt bewegt werden können. Im betätigten Zustand stören bzw. unterbrechen die metallenen Abschnitte eine Wirkverbindung zwischen einer Sende- und einer Empfängerspule, wodurch die Schaltposition des Stellelements detektiert werden kann.

Vor diesem Hintergrund ist es eine Aufgabe der vorliegenden Erfindung, einen Sicherheitsschalter anzugeben, der als Not-Aus-Schalter oder als vergleichbarer mechanisch betätigter Sicherheitsschalter verwendbar ist und dessen Funktionsfähigkeit auch ohne äußere Betätigung getestet werden kann, um dadurch den Aufwand für externe Funktionsüberprüfungen zu reduzieren.

Diese Aufgabe wird gemäß einem Aspekt der Erfindung mit einem Sicherheitsschalter der eingangs genannten Art gelöst, wobei der Sicherheitsschalter ein mechanisch betätigter Sicherheitsschalter mit einem Schaltergehäuse ist, an dem das Stellelement und in dem das Detektorelement, ein Abschirmelement zum selektiven Abschirmen elektromagnetischer Signale sowie ein Schaltelement angeordnet sind, mit dessen Hilfe das Auslesen der Transponderkennung gezielt unterdrückbar ist, wobei das Abschirmelement und der Transponder und/oder die Leseeinheit in Abhängigkeit von dem Stellelement relativ zueinander beweglich sind.

Der neue Sicherheitsschalter besitzt hiernach also einen in aller Regel räumlich von der Leseeinheit getrennt angeordneten Transponder. Leseeinheit und Transponder kommunizieren zum Auslesen der Transponderkennung, wie bei Transpondern üblich, drahtlos miteinander, d.h. über zumindest ein elektromagnetisches Signal. Die Anordnung von Transponder, Leseeinheit und beweglichem Stellelement ist so gewählt, dass die drahtlose Kommunikation abreißt (unterbunden wird), wenn das Stellelement von der ersten in die zweite Position bewegt wird. Anders ausgedrückt ist die drahtlose Kommunikation hier nur möglich, wenn sich das Stellelement in der ersten Position befindet. Abhängig davon, ob die Leseeinheit die Transponderkennung auslesen kann oder nicht, kann dann auf die Position des Stellelements zurückgeschlossen werden.

Mit Hilfe des Abschirmelements kann der Ausbreitungspfad von elektromagnetischen Wellen, auf denen die drahtlose Kommunikation zwischen Transponder und Leseeinheit beruht, gezielt begrenzt werden. Infolgedessen wird das Ansprechverhalten des neuen Sicherheitsschalters kontrollierter, was zu einer Erhöhung der Funktionssicherheit beiträgt. Außerdem kann aufgrund der verwendung eines solchen Abschirmelements der detektierbare Schaltweg des Stellelements deutlich reduziert werden, so dass die erste und zweite Position, die voneinander unterschieden werden müssen, räumlich sehr eng beieinander liegen können. Infolgedessen kann die Baugröße des neuen Sicherheitsschalters reduziert werden. Außerdem führt die höhere Empfindlichkeit zu einer schnellen und damit auch sicheren Funktion.

Mit Hilfe des Schaltelements kann auf einfache weise eine Testfunktion realisiert werden. Insbesondere ist es hierdurch möglich, dass ein übergeordnetes Steuergerät das Auslesen der Transponderkennung zyklisch unterdrückt, um zu überprüfen, ob der neue Sicherheitsschalter entsprechend reagiert. Die Ausbildung ermöglicht es, den Sicherheitskreis des neuen Sicherheitsschalters einkanalig auszubilden, so dass weniger Bauteile und Bauraum benötigt werden. Darüber hinaus kann die bei bisherigen Sicherheitsschaltern durchgeführte manuelle Funktionsüberprüfung in dieser Ausgestaltung automatisiert durchgeführt werden, was die Einhaltung vorgegebener Standards und die Akzeptanz des neuen Sicherheitsschalters vereinfacht.

Mit einer solchen Anordnung ist es überraschenderweise möglich, die Position des Stellelements und damit den Betätigungszustand auch bei einem mechanisch betätigten, gewissermaßen also einteiligen Sicherheitsschalter (im Unterschied zu berührungslos arbeitenden, daher per se zweiteiligen Signalgebern) zuverlässig zu überwachen. Dies war aufgrund der geringen Bewegungshübe des Stellelements bei solchen Sicherheitsschaltern nicht von vornherein zu erwarten. Praktische Versuche haben nun jedoch gezeigt, dass auch bei einteiligen, mechanisch betätigten Sicherheitsschaltern eine vorteilhafte Verwendung von Transpondern zur Auswertung des Betätigungszustandes möglich, ist,

Die Verwendung eines Transponders besitzt dabei aufgrund der individuellen Transponderkennung schon von sich aus eine höhere Sicherheit gegenüber Manipulationen und Fehldetektionen als beispielsweise Gabellichtschranken und andere bislang bekannte Detektorelemente. Da die Kommunikation zwischen Transponder und Leseeinheit zudem ein dynamischer, d.h. stetig zu wiederholender Vorgang ist, wird jede Funktionsstörung innerhalb des Sicherheitsschalters automatisch erkannt.

Darüber hinaus ist es bei einem Transponder leicht möglich, die Kommunikation zwischen Transponder und Leseeinheit gezielt zu unterbrechen, ohne dass das Stellelement mechanisch betätigt werden muss. Daher kann der neue Sicherheitsschalter auf "elektronische" Art auf seine Funktionsfähigkeit getestet werden, was es zumindest grundsätzlich ermöglicht, die bislang üblichen manuellen Funktionskontrollen zu reduzieren oder sogar ganz wegzulassen.

Der neue Sicherheitsschalter besitzt darüber hinaus den Vorteil, dass auf die Verwendung von kontaktbehafteten Detektorelementen verzichtet werden kann, weshalb der neue Sicherheitsschalter vollkommen verschleißfrei arbeiten kann. Andererseits kann in Ergänzung zu einem Transponder auch weiterhin ein kontaktbehaftetes Schaltelement als Detektorelement verwendet werden, insbesondere um die Kompatibilität zu bisherigen Sicherheitsschaltern zu bewahren. Des weiteren würde in diesem Fall eine diversitäre Redundanz geschaffen, die eine nochmals erhöhte Funktionssicherheit ermöglicht.

Als weiterer Vorteil kann der neue Sicherheitsschalter aufgrund der vorhandenen Transponderkennung recht einfach drahtlos an eine übergeordnete Auswerteeinheit angeschlossen werden. Dies reduziert vor allem bei weitläufigen Anlagen den Verkabelungsaufwand.

In einer bevorzugten Ausgestaltung des neuen Sicherheitsschalters stellt die erste Position die Ruheposition des Stellelements dar.

Dies ist besonders vorteilhaft für eine Anwendung als Not-Aus-Schalter, da ein Ausfall des aktiven, dynamischen Transpondersignals hierdurch automatisch zum Abschalten der überwachten Anlage führt. Auswertung und Installation des neuen Sicherheitsschalters wird hierdurch vereinfacht.

In einer weiteren Ausgestaltung ist der Transponder an dem beweglichen Stellelement angeordnet. Vorzugsweise ist der Transponder dabei als passiver Transponder ausgebildet.

Passive Transponder, d.h. solche, die ohne eigene Energiequelle arbeitsfähig sind, sind bereits seit langem kommerziell erhältlich. Sie werden beispielsweise in Wegfahrsperren bei Kraftfahrzeugen oder bei der Massentierhaltung zur Identifikation der einzelnen Tiere verwendet. Aufgrund der dabei anfallenden hohen Stückzahlen stehen passive Transponder als kostengünstige Bauelemente zur Verfügung. Ein passiver Transponder kann an dem beweglichen Stellelement sehr einfach befestigt werden, beispielsweise verklebt werden, was eine günstige Fertigung ermöglicht. Darüber hinaus kann die Position des Stellelements in dieser Ausgestaltung sehr zuverlässig bestimmt werden, da sich der Transponder mit dem Stellelement zwangsläufig mitbewegt.

In einer weiteren Ausgestaltung besitzt der neue Sicherheitsschalter ein erstes Abschirmelement zum selektiven Abschirmen elektromagnetischer Signale, wobei das Abschirmelement und der Transponder und/oder die Leseeinheit in Abhängigkeit von dem Stellelement relativ zueinander beweglich sind.

In einer weiteren Ausgestaltung weist das erste Abschirmelement eine Ausnehmung auf, die in der ersten Position des Stellelements auf einer im Wesentlichen geraden Verbindungslinie zwischen dem Transponder und der Leseeinheit liegt.

In dieser Ausgestaltung arbeitet das erste Abschirmelement gewissermaßen als Lochblende, durch die hindurch die Kommunikation zwischen Transponder und Leseeinheit stattfindet. Verschiebt man auch nur eines der drei Elemente, also entweder den Transponder und/oder die Leseeinheit und/oder die Ausnehmung des Abschirmelements, relativ zu den anderen, reißt die Kommunikation sehr schnell ab. Durch geeignete Dimensionierung der Ausnehmung ("Lochblende") kann das Schaltverhalten des neuen Sicherheitsschalters sehr exakt bestimmt werden. Darüber hinaus ist es in dieser Ausgestaltung möglich, den Transponder und/oder die Leseeinheit weitgehend oder sogar vollständig in dem Abschirmelement zu verkapselt, wodurch die Funktionssicherheit des neuen Sicherheitsschalters nochmals erhöht wird.

In einer weiteren Ausgestaltung ist das erste Abschirmelement an dem Stellelement angeordnet. Das erste Abschirmelement kann hiernach beispielsweise starr an dem Stellelement befestigt sein, so dass es dessen Bewegungen folgt. Des weiteren kann das erste Abschirmelemente hiernach auch Teil des Stellelements sein, d.h. dass Stellelement fungiert hiernach gleichzeitig auch als erstes Abschirmelement.

Die Kopplung von Abschirmelement und Stellelement ist eine einfache Möglichkeit, um durch Verschieben des Stellelements ein Abreißen der Kommunikation zwischen Transponder und Leseeinheit zu erreichen. Das Stellelement wirkt dabei gewissermaßen als Tor, das einen Kommunikationspfad zwischen Transponder und Leseeinheit nur im geöffneten Zustand freigibt, jedoch nicht im geschlossenen Zustand. Die Ausgestaltung besitzt den Vorteil, dass sowohl der Transponder als auch die Leseeinheit ortsfest in dem Sicherheitsschalter angeordnet werden können, was die Freiheitsgrade bei der praktischen Realisierung erhöht. Insbesondere wird hierdurch eine Optimierung des Ansprechverhaltens durch Wahl der Entfernung zwischen Transponder und Leseeinheit möglich.

In einer weiteren Ausgestaltung besitzt das erste Abschirmelement einen im Wesentlichen quer zu einer Bewegungsrichtung des Stellelements verlaufenden Abschnitt mit einer Öffnung zum Durchtritt des Stellelements.

In dieser Ausgestaltung taucht das Stellelement gewissermaßen bei Betätigung des Sicherheitsschalters in einen von dem ersten Abschirmelement abgeschirmten Bereich ein. Da das erste Abschirmelement hierdurch im Gegensatz zu dem Stellelement starr an einer Träger- oder Gehäusewand befestigt werden kann, kann das Abschirmelement relativ großflächig ausgebildet werden. Die Abschirmwirkung kann daher vorteilhaft im Hinblick auf maximale Funktionssicherheit optimiert werden.

In einer weiteren Ausgestaltung weist das erste Abschirmelemente einen Signalpfad zum definierten Übertragen eines elektromagnetischen Signals auf.

Diese Ausgestaltung beruht auf der Idee, für die Kommunikation zwischen Transponder und Leseeinheit von vornherein nur einen einzigen definierten Übertragungsweg bereitzustellen, anstatt mögliche unerwünschte Übertragungswege im Nachhinein durch ein Abschirmelement zu versperren. Der Signalpfad kann beispielsweise in Form eines Wellenleiters realisiert sein, aus dem die übertragenen Signale nur an gezielten Stellen austreten können. Durch diese Maßnahme lässt sich eine besonders hohe Funktionssicherheit erreichen.

In einer weiteren Ausgestaltung ist der Transponder in einem zweiten Abschirmelement, vorzugsweise in einer einseitig offenen Abschirmbuchse angeordnet.

In einer weiteren Ausgestaltung weist die Leseeinheit eine Empfangsspule auf, die in einem dritten Abschirmelement angeordnet ist.

Durch diese beiden Ausgestaltungen kann die Funktionssicherheit des neuen Sicherheitsschalters weiter gesteigert werden, da die Abstrahl- bzw. Empfangscharakteristik des Transponders und der Leseeinheit auf einen noch engeren Bereich fokussiert wird. Insbesondere kann durch diese Maßnahme verhindert werden, dass eine Kommunikation über Nebenkeulen in den jeweiligen Abstrahlcharakteristiken auftreten kann. Die Ansprechgenauigkeit des neuen Sicherheitsschalters ist nochmals erhöht.

In einer weiteren Ausgestaltung sind die Abschirmelemente elektrische leitfähige, nicht-ferromagnetische Abschirmelemente, vorzugsweise aus Aluminium, Kupfer, Silber, Gold oder einer Kombination davon.

Alternativ hierzu können elektromagnetische Wellen bekanntermaßen auch durch magnetisch wirksame Abschirmelemente, wie etwa Ferrite, beeinflusst werden. Es hat sich jedoch gezeigt, dass bei den typischen Entfernungen und Frequenzen, die hier aufgrund des vorgegebenen Verwendungszwecks auftreten, elektrisch leitfähige, magnetisch weitgehend wirkungslose Abschirmelemente effektiver sind. Die Abschirmung kann daher genauer erfolgen. Die Funktionssicherheit ist weiter erhöht.

In einer weiteren Ausgestaltung besitzt der Sicherheitsschalter einen Drucksensor, mit dessen Hilfe ein Betätigungsdruck auf dem Stellelement detektierbar ist.

Mit einem solchen Drucksensor kann die Betätigung des neuen Sicherheitsschalters redundant zu der Auswertung der Position des Stellelements erkannt werden. Die Funktionssicherheit ist dementsprechend noch weiter erhöht. Darüber hinaus bietet ein solcher Drucksensor die Möglichkeit, eine Betätigung des neuen Sicherheitsschalter auch dann zu erkennen, wenn das Stellelement beispielsweise verklemmt oder anderweitig an einer Bewegung gehindert ist. Mit einem Drucksensor könnte der neue Sicherheitsschalter daher auch in Bereichen eingesetzt werden, in denen starke Verschmutzungen auftreten, beispielsweise bei Lackieranlagen, die eine mechanische Betätigung beeinträchtigen können.

In einer weiteren Ausgestaltung ist das Stellelement aus einem korrosionsfreien Material hergestellt und/oder staubfrei gekapselt.

Auch diese Ausgestaltungen tragen dazu bei, eine Immobilität des Stellelements zu verhindern, was einen entsprechenden Fehlerausschluss ermöglicht. Die Häufigkeit manueller Funktionskontrollen kann daher weiter reduziert werden.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine vereinfachte Darstellung einer automatisiert arbeitenden Anlage, in der ein Ausführungsbeispiel des neuen Sicherheitsschalters verwendet wird;
- Fig. 2 und 3: ein Ausführungsbeispiel des neuen Sicherheitsschalters in zwei verschiedenen Betriebsstellungen;
- Fig. 4: ein vereinfachtes Schaltbild des Transponders und der Leseeinheit bei dem Sicherheitsschalter aus Fig. 2 und 3;
- Fig. 5 und 6: ein weiteres Ausführungsbeispiel des neuen Sicherheitsschalters in zwei unterschiedlichen Betriebszuständen;
- Fig. 7 und 8: ein weiteres Ausführungsbeispiel des neuen Sicherheitsschalters in zwei unterschiedlichen Betriebszuständen; und
- Fig. 9 und 10: eine vereinfachte Prinzipdarstellung für ein weiteres Ausführungsbeispiel des neuen Sicherheitsschalters.

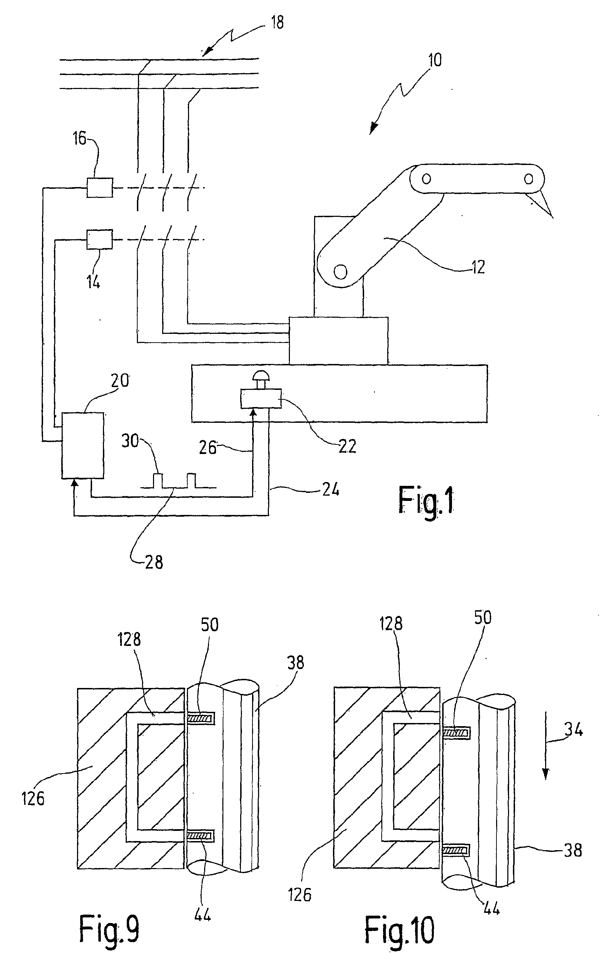

In Fig. 1 ist eine automatisiert arbeitende Anlage, in der ein Ausführungsbeispiel des neuen Sicherheitsschalters zum Einsatz kommt, in der Gesamtheit mit der Bezugsziffer 10 bezeichnet.

Die Anlage 10 beinhaltet hier beispielhaft einen Roboter 12. Die Erfindung ist jedoch darauf nicht beschränkt und kann gleichermaßen bei allen Anlagen verwendet werden, bei denen mechanisch betätigte Sicherheitsschalter zum Einsatz kommen.

Der Roboter 12 ist hier in an sich bekannter Weise über zwei Schütze 14, 16 an eine Stromversorgung 18 angeschlossen. Die Arbeitskontakte der Schütze 14, 16 liegen in Reihe zueinander, um redundante Abschaltwege zu realisieren. Angesteuert werden die Schütze 14, 16 von einem Sicherheitsschaltgerät 20 oder einer anderen geeigneten Sicherheitssteuerung. Eingangsseitig ist an das Sicherheitsschaltgerät 20 ein Not-Aus-Schalter 22 gemäß einem Ausführungsbeispiel der Erfindung angeschlossen. Die Verwendung als Not-Aus-Schalter ist ein bevorzugtes Ausführungsbeispiel der Erfindung. Die Erfindung ist hierauf jedoch nicht beschränkt und kann gleichermaßen bei anderen mechanisch betätigten (einteiligen) Sicherheitsschaltern angewendet werden.

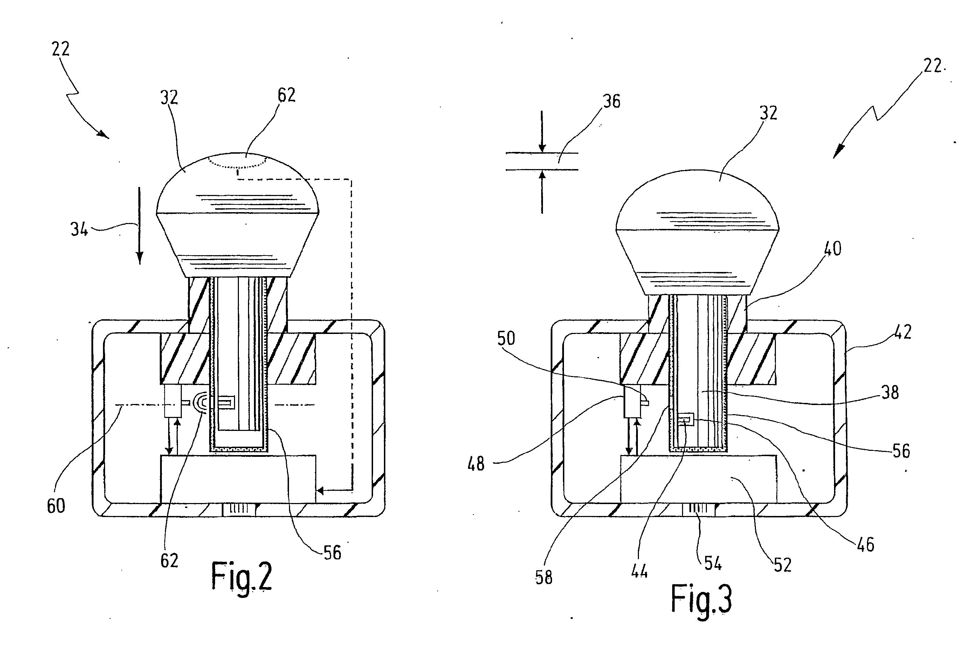

Der Not-Aus-Schalter 22 liefert über eine Verbindung 24 ein Ausgangssignal an das Sicherheitsschaltgerät 20 und erhält von diesem über eine zweite Verbindung 26 ein Steuersignal 28 mit Testimpulsen 30. Damit besitzt das Sicherheitsschaltgerät 20 die Möglichkeit, den Not-Aus-Schalter 22 auf seine Funktionsfähigkeit hin zu überprüfen, wie nachfolgend noch näher erläutert wird. Erkennt das Sicherheitsschaltgerät 20 aufgrund der Verbindung 24 zum Not-Aus-Schalter 22 einen undefinierten oder unsicheren Zustand oder wird der Not-Aus-Schalter 22 manuell betätigt und ein entsprechendes Signal über die Verbindung 24 an das Sicherheitsschaltgerät 20 gesendet, schaltet das Sicherheitsschaltgerät 20 über die Schütze 14, 16 den Roboter 12 ab. In den Figuren 2 und 3 ist der Not-Aus-Schalter 22 in seinen beiden möglichen Betriebszuständen dargestellt. Fig. 2 zeigt den Not-Aus-Schalter 22 im unbetätigten Zustand, d.h. dem Ruhezustand. Fig. 3 zeigt den Not-Aus-Schalter 22 nach einer Betätigung. Mit der Betätigung wurde der Bedienknopf 32 des Not-Aus-Schalter 22 in Richtung des Pfeils 34 nach unten gedrückt. Der zugehörige Bewegungshub ist in Fig. 3 bei der Bezugsziffer 36 angedeutet.

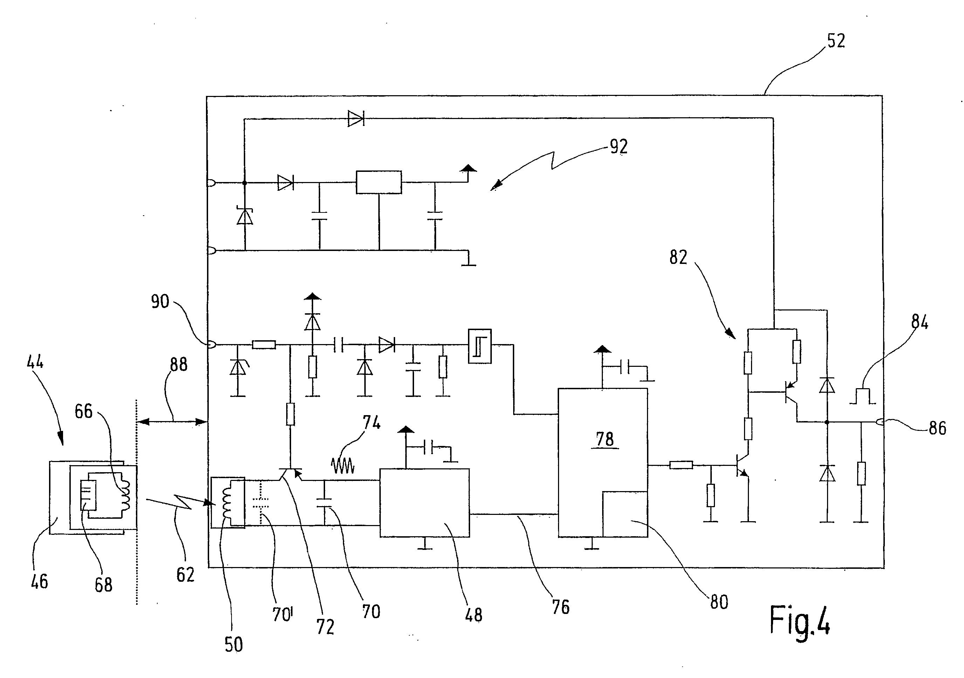

Der Not-Aus-Schalter 22 besitzt ein mit dem Bedienknopf 32 starr verbundenes Stellelement 38. Das Stellelement 38 ist in Richtung des Pfeils 34 beweglich in einer Aufnahme 40 gelagert, die ihrerseits an einem Schaltergehäuse 42 befestigt ist. Am freien Ende des Stellelements 38 ist ein handelsüblicher, passiver Transponder 44 angeordnet, dessen Funktionsweise anhand Fig. 4 nachfolgend noch näher erläutert ist. Gemäß einem bevorzugten Ausführungsbeispiel ist der Transponder 44 hier in einer Abschirmbuchse 46 verklebt, die den Transponder 44 rohrförmig umgibt und nur an einer Seite (nämlich der linken Seite in den Figuren 2 und 3) offen ist.

Mit der Bezugsziffer 48 ist eine Leseeinheit zum Auslesen des Transponders 44 bezeichnet. Die Leseeinheit 48 wird in der Fachterminologie teilweise auch als Tag-Reader bezeichnet, und sie besitzt an ihrer dem Transponder 44 zugewandten Seite eine Empfangsspule 50, über die sie drahtlos mit dem Transponder 44 kommuniziert.

Mit der Bezugsziffer 52 ist eine Auswertelogik bezeichnet, die die Leseeinheit 48 ansteuert und deren Ausgangssignale aufnimmt. Abweichend von dieser hier funktionsblockartigen DarStellung können die Leseeinheit 48 mit Empfangsspule 50 und die Auswertelogik 52 auch in einer kombinierten Schaltung verbunden sein.

Mit der Bezugziffer 54 ist eine Anschlussbachse zum Anschließen der Verbindungen 24, 26 (Fig. 1) bezeichnet. Alternativ hierzu ist es aufgrund der erfindungsgemäßen Verwendung eines Transponders jedoch auch möglich, dass der Not-Aus-Schalter 22 drahtlos mit dem Sicherheitsschaltgerät 20 bzw. einer entsprechenden Sicherheitssteuerung kommuniziert.

Mit der Bezugsziffer 56 ist ein Abschirmelement bezeichnet, das das Stellelement 38 hier hülsenartig umgibt. Das Abschirmelement 56 besitzt eine Ausnehmung 58, die so angeordnet ist, dass sie im Ruhezustand des Not-Aus-Schalter 22 auf einer gedachten Verbindungslinie 60 zwischen der Leseeinheit 48 (genauer deren Empfangsspule 50) und dem Transponder 44 liegt. Infolgedessen ist im Ruhezustand des Not-Aus-Schalters 22 eine drahtlose Kommunikation zwischen dem Transponder 44 und der Leseeinheit 48 möglich, was in Fig. 2 bei der Bezugsziffer 62 angedeutet ist.

Befindet sich das Stellelement 38 hingegen in der in Fig. 3 gezeigten Position, liegen der Transponder 44, die Empfangsspule 50 und die Ausnehmung 58 nicht mehr auf einer geraden Verbindungslinie. Aufgrund des Abschirmelements 56 kann daher keine Kommunikation zwischen der Leseeinheit 48 und dem Transponder 44 stattfinden. Das Abreißen der Kommunikation wird von der Auswertelogik 52 erkannt und über die Verbindung 24 dem Sicherheitsschaltgerät 20 mitgeteilt. Dieses schaltet daraufhin den Roboter 12 ab.

In dem in Fig. 2 und 3 dargestellten Ausführungsbeispiel bewegt sich das Stellelement 38 mit dem Transponder 44 relativ zu der feststehenden Leseeinheit 48 und dem ebenfalls feststehenden Abschirmelement 56. Alternativ hierzu wäre es grundsätzlich auch möglich, dass die Leseeinheit 48 und/oder das Abschirmelement 56 über das Stellelement 38 bewegt werden.

In dem in Fig. 2 und 3 gezeigten Ausführungsbeispiel ist der lichte Innendurchmesser des hülsenförmigen Abschirmelements 56 nur geringfügig größer als der Außendurchmesser des Stellelements 38. Infolgedessen bildet das Abschirmelement 56 in Verbindung mit der Abschirmbuchse 46 eine fast geschlossene Abschirmung des Transponders 44, wenn sich das Stellelement 38 in der in Fig. 3 gezeigten Position befindet. Bevorzugt sind die Abschirmbuchse 46 und das Abschirmelement 56 zumindest teilweise aus elektrisch leitfähigen Materialien, hier insbesondere Kupfer oder Aluminium hergestellt.

Mit der Bezugsziffer 62 ist in Fig. 2 ein Drucksensor bezeichnet, der in einem abgewandelten Ausführungsbeispiel im Bedienknopf 32 angeordnet ist. Das Ausgangssignal des Drucksensors 62 ist der Auswertelogik 52 zugeführt, um einen zweiten Weg zum Detektieren einer Betätigung bereitzustellen.

In Fig. 4 sind der Transponder 44 und die Leseeinheit 48 in einem vereinfachten elektrischen Schaltbild dargestellt. Gleiche Bezugszeichen bezeichnen jeweils dieselben Elemente wie zuvor.

Der Transponder 44 besitzt in an sich bekannter Weise eine Sende- und Empfangsspule 66 sowie einen Speicher, in dem eine individuelle Transponderkennung 68 abgespeichert ist. Die Leseeinheit 48 ist ein kommerziell erhältlicher integrierter Schaltkreis zum Auslesen der Transponderkennung 68. Für die drahtlose Kommunikation ist die Leseeinheit 48 mit einem Schwingkreis verschaltet, der die bereits erwähnte Empfangsspule 50 sowie eine parallel dazu angeordnete Kapazität 70 beinhaltet. Zwischen der Spule 50 und der Kapazität 70 ist in dem bevorzugten Ausführungsbeispiel ein Transistor 72 angeordnet, mit dessen Hilfe der Schwingkreis aufgetrennt und damit funktionsunfähig gemacht werden kann. Der Transistor 72 fungiert als Testelement, mit dessen Hilfe das Auslesen der Transponderkennung 68 "elektronisch" unterdrückt werden kann. Alternativ zu der gezeigten Anordnung könnte der Transistor 72 auch so geschaltet sein, dass er den Schwingkreis aus Spule 50 und Kapazität 70 von der Leseeinheit 48 trennt, was bei der Bezugsziffer 70' angedeutet ist.

Die Leseeinheit 48 erzeugt in an sich bekannter Weise mit Hilfe des Schwingkreises 50, 70 ein elektromagnetisches Abfragesignal. Befindet sich der Transponder 44 nahe genug an dem Schwingkreis 50, 70, wird er durch das Signal aktiviert und sendet seinerseits ein Signal, das als Information die individuelle Transponderkennung 68 trägt. Dieses Antwortsignal, in Fig. 4 bei der Bezugsziffer 74 angedeutet, wird über den Schwingkreis 50, 70 aufgenommen und der Leseeinheit 48 zur Auswertung zur Verfügung gestellt. Die Leseeinheit 58 liest aus dem Antwortsignal 74 die individuelle Transponderkennung 68 aus und stellt sie über eine Verbindung 76 einem Mikroprozessor 78 zur Verfügung. Der Mikroprozessor 78 besitzt in einem internen Speicher 80 einen Vergleichswert, anhand dessen er überprüfen kann, ob die ausgelesene Transponderkennung 68 mit dem erwarteten Wert übereinstimmt. Ist dies der Fall, gibt der Mikroprozessor 78 über eine Verstärkerschaltung 82 ein entsprechendes Ausgangssignal 84 an einem Ausgang 86 aus. Das Ausgangssignal 84 ist über die Verbindung 24 dem Sicherheitsschaltgerät 22 zugeführt.

Wie bei passiven Transpondern üblich, funktioniert das Auslesen der Transponderkennung 68 in dieser Anordnung nur, solange sich der Transponder 44 nahe genug an dem Sende- und Empfangskreis der Leseeinheit 48 befindet. Eine maximale Entfernung, innerhalb der ein Auslesen der Transponderkennung 68 möglich ist, ist in Fig. 4 bei der Bezugsziffer 88 angedeutet.

Bei dem neuen Sicherheitsschalter 22 sind der Transponder 44 und der Sende- und Empfangskreis aus Spule 50 und Kapazität 70 so zueinander angeordnet, dass die maximale Entfernung 88 in der zweiten Position (Fig. 3) des Stellelements 38 überschritten ist. Demgegenüber befindet sich der Transponder 44 nahe genug an der Leseeinheit 48, wenn sich das Stellelement 38 in der ersten Position (Fig. 2) befindet. Beim Verschieben des Stellelements 38 von der ersten in die zweite Position reißt die Kommunikation zwischen Transponder 44 und Leseeinheit 48 ab. Dies wird vom Mikroprozessor 78 detektiert und über die Verbindung 24 dem Sicherheitsschaltgerät 22 gemeldet.

Mit der Bezugsziffer 90 ist in Fig. 4 ein Testeingang bezeichnet, über den das Sicherheitsschaltgerät 20 den Transistor 72 ein- bzw. ausschalten kann. Da beim Ausschalten des Transistors 72 kein Antwortsignal 74 mehr generiert und an die Leseeinheit 48 gelangen kann, entspricht dies der Situation, dass der Transponder 44 aus dem Bereich der Leseeinheit 48 entfernt wurde. Der Mikroprozessor 78 muss dementsprechend genauso reagieren, wie in dem Fall, dass das Stellelement 38 bewegt wurde. Tut er dies nicht, kann das Sicherheitsschaltgerät 22 dies anhand des Ausgangssignals 84 erkennen und den Roboter 12 vorsorglich abschalten.

In dem bevorzugten Ausführungsbeispiel besitzt der Not-Aus-Schalter 22 eine eigene Versorgungsspannung, die hier über eine Spannungsreglerschaltung 92 bereitgestellt wird. Damit ist es möglich, den neuen Not-Aus-Schalter 22 mit unterschiedlichen externen Versorgungsspannungen zu betreiben, was dessen Installation in weitläufigen Anlagen vereinfacht.

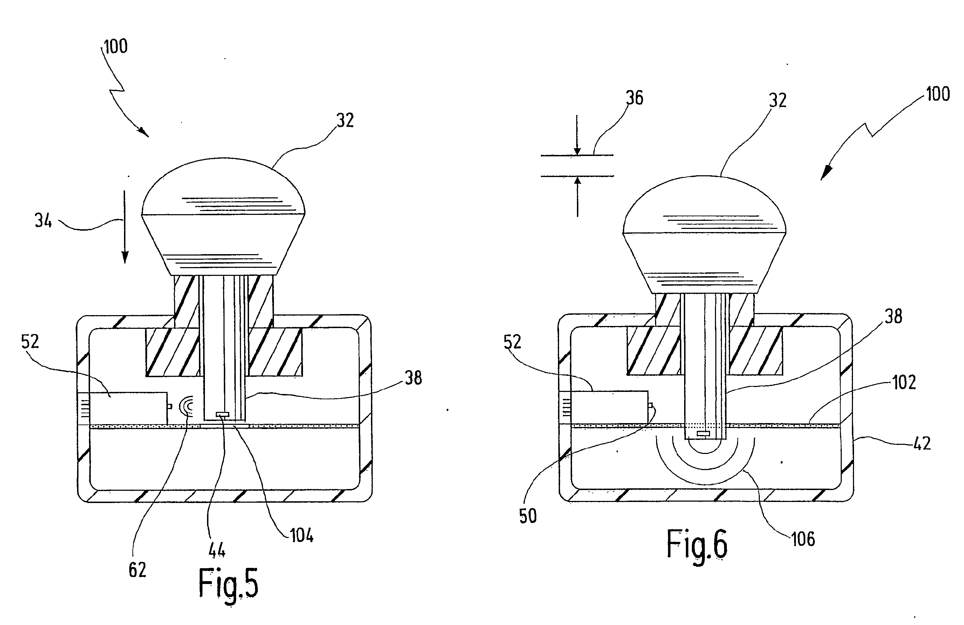

In den Fig. 5 und 6 ist ein weiteres Ausführungsbeispiel des neuen Sicherheitsschalters in seiner Gesamtheit mit der Bezugsziffer 100 bezeichnet. Der Sicherheitsschalter 100 ist hier der Einfachheit halber wiederum als Not-Aus-Schalter dargestellt. Gleiche Bezugszeichen bezeichnen dieselben Elemente wie zuvor.

Der Sicherheitsschalter 100 besitzt anstelle des hülsenartigen Abschirmelements 56 aus Fig. 2, 3 ein hier im Wesentlichen plattenförmiges Abschirmelement 102. Dieses ist im Wesentlichen quer zu der Bewegungsrichtung 34 des Stellelements 38 angeordnet und besitzt zum Durchtritt des Stellelements 38 eine Öffnung 104. Der Transponder 44 ist wiederum am freien Ende des Stellelements 38 befestigt.

In der in Fig. 5 dargestellten Ruheposition befindet sich der Transponder 44 oberhalb des Abschirmelements 102, wo auch die Auswertelogik 52 mit der Leseeinheit 48 (hier nicht gezeigt) und der Empfangsspule 50 angeordnet ist. In dieser Position kann eine Kommunikation zwischen dem Transponder 44 und der Leseeinheit 48 erfolgen, d.h. die Leseeinheit 48 liest die individuelle Transponderkennung zyklisch aus dem Transponder 44 aus.

Nach der Betätigung des Stellelements 38 befindet sich der Transponder 44 hingegen unterhalb des Abschirmelements 102. Zudem ist die Öffnung 104 dann durch das Stellelement 38 verschlossen. Infolgedessen ist der Transponder 44 dann von der Leseeinheit 48 abgeschirmt. Es kann keine Kommunikation stattfinden (angedeutet bei Bezugsziffer 106; zur Klarstellung sei darauf hingewiesen, dass von einem passiven Transponder 44 in dieser Stellung keinerlei Signale ausgehen, statt dessen jedoch die Empfangsspule 50 weiterhin Abfrageimpulse sendet). Alternativ zu der hier gezeigten Darstellung könnte das Abschirmelement 102 hier auch topfförmig ausgebildet sein, wobei das Stellelement 38 in der zweiten Position in den entsprechenden Topf "eintaucht".

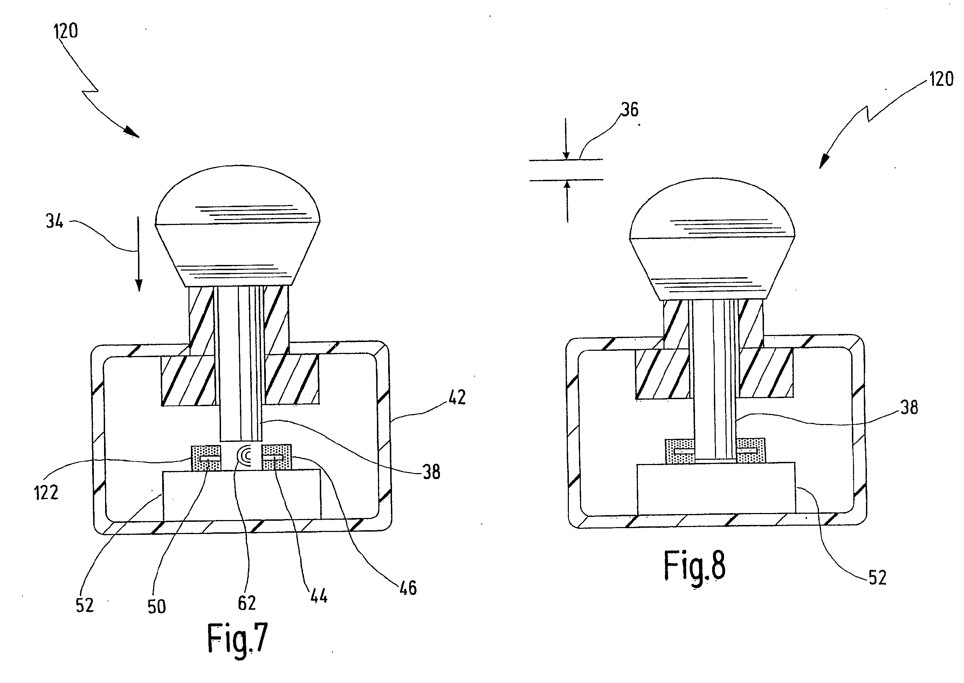

In den Fig. 7 und 8 ist ein weiteres Ausführungsbeispiel des neuen Sicherheitsschalters in seiner Gesamtheit mit der Bezugsziffer 120 bezeichnet. In diesem Ausführungsbeispiel sind sowohl die Leseeinheit mit der Empfangsspule 50 als auch der Transponder 44 ortsfest in dem Gehäuse 42 des Sicherheitsschalters 120 angeordnet. Sowohl der Transponder 44 als auch die Empfangsspule 50 sind dabei in einer Abschirmbuchse 46 bzw. 122 verklebt. Der Transponder 44 und die Empfangsspule 50 liegen sich einander diametral gegenüber, wobei in den verbleibenden Zwischenraum das freie Ende des Stellelements 38 eintauchen kann. In der in Fig. 7 gezeigten, nicht-betätigten Position stört das Stellelement 38 die Kommunikation zwischen Transponder 44 und Leseeinheit 48 nicht. Dementsprechend kann die Leseeinheit 48 die Transponderkennung zyklisch auslesen. In der in Fig. 8 gezeigten Position verschließt das freie Ende des Stellelements 38 hingegen die beiden Abschirmbuchsen 46, 122, wodurch die Kommunikation zwischen Transponder 44 und Leseeinheit 48 unterbrochen wird.

Fig. 9 und 10 zeigen ein weiteres Ausführungsbeispiel des neuen Sicherheitsschalters. In diesem Fall sind sowohl der Transponder 44 als auch die Empfangsspule 50 der Leseeinheit 48 an dem beweglichen Stellelement 38 angeordnet. Ein Abschirmelement 126 ist so ausgebildet, dass es einen Signalpfad 128 bereitstellt, über den die Leseeinheit und der Transponder miteinander kommunizieren können, wenn sich das Stellelement 38 in der in Fig. 9 gezeigten Position befindet. Ist das Stellelement 38 demgegenüber in seine zweite Position verschoben, schließen der Transponder 44 und die Empfangsspule 50 der Leseeinheit nicht mehr an den Signalpfad 28 an. Daher reißt wiederum die Kommunikation ab, was von der Auswertelogik 52 entsprechend detektiert wird.

In einem weiteren Ausführungsbeispiel kann ein solcher Signalpfad grundsätzlich auch verwendet werden, wenn der Transponder und/oder die Leseeinheit getrennt vom Stellelement angeordnet sind. Das Prinzip, einen einzigen definierten Signalpfad für die Übertragung bereitzustellen, der bei Verstellen des Stellelements abreißt, bleibt dabei bestehen.

In den Äusführungsbeispielen aus den Figuren 7, 8, 9 und 10 ist es bevorzugt, wenn das Stellelement 38 selbst so ausgebildet ist, dass der Durchgang von elektromagnetischen Signalen verhindert oder zumindest gedämpft ist. Abhängig von den verwendeten Frequenzen für die Kommunikation zwischen Transponder und Leseeinheit sind den einschlägigen Fachleuten hier verschiedene Materialien bekannt, die bei der jeweiligen Frequenz eine hinreichende Dämpfung besitzen. Bei der für handelsübliche Transponder typischen Frequenz von 125 kHz wird bevorzugt ein elektrisch leitfähiges, jedoch nicht magnetisches Material, wie Aluminium, Kupfer, Silber oder Gold verwendet. Beispielsweise kann die Kupferkaschierung einer handelsüblichen Leiterplatte gut verwendet werden.

## Patentansprüche

1. Sicherheitsschalter, insbesondere Not-Ausschalter, zum sicheren Abschalten eines gefahrbringenden Gerätes (12), mit einem mechanisch betätigten Stellelement (38), das zwischen einer ersten und zumindest einer zweiten Position bewegbar ist, und mit einem Detektorelement zum Detektieren des Stellelements (38) in zumindest einer der genannten Positionen, wobei das Detektorelement einen Transponder (44) mit einer individuellen Transponderkennung (68) und eine zum Auslesen der Transponderkennung (68) ausgebildete Leseeinheit (48) beinhaltet, und wobei der Transponder (44) und die Leseeinheit (48) so zueinander angeordnet sind, dass die Leseeinheit (48) den Transponder (44) in der ersten Position des Stellelements (38), nicht jedoch in dessen zweiter Position auslesen kann, **dadurch gekennzeichnet, dass** der Sicherheitsschalter ein mechanisch betätigter Sicherheitsschalter mit einem Schaltergehäuse (42) ist, an dem das Stellelement (38) und in dem das Detektorelement, ein Abschirmelement (56; 102; 126) zum selektiven Abschirmen elektromagnetischer Signale (62) und ein Schaltelement (72) angeordnet sind, mit dessen Hilfe das Auslesen der Transponderkennung (68) gezielt unterdrückbar ist, wobei das Abschirmelement (56; 102; 126) und der Transponder (44) und/oder die Leseeinheit (48) in Abhängigkeit von dem Stellelement (38) relativ zueinander beweglich sind.

2. Sicherheitsschalter nach Anspruch 1, **dadurch gekennzeichnet, dass** der Transponder (44) an dem beweglichen Stellelement (38) angeordnet ist.

3. Sicherheitsschalter nach Anspruch 1 oder 2, **dadurch gekennzeichnet, dass** das Abschirmelement (56) eine Ausnehmung aufweist, die in der ersten Position des Stellelements (38) auf einer im Wesentlichen geraden Verbindungslinie (60) zwischen dem Transponder (44) und der Leseeinheit (48) liegt.

4. Sicherheitsschalter nach einem der Ansprüche 1 bis 3, **dadurch gekennzeichnet, dass** das Abschirmelement an dem Stellelement angeordnet ist.

5. Sicherheitsschalter nach einem der Ansprüche 1 bis 3, **dadurch gekennzeichnet, dass** das Abschirmelement (102) einen im Wesentlichen quer zu einer Bewegungsrichtung (34) des Stellelements (38) verlaufenden Abschnitt mit einer Öffnung (104) zum Durchtritt des Stellelements (38) aufweist.

6. Sicherheitsschalter nach einem der Ansprüche 1 bis 3, **dadurch gekennzeichnet, dass** das Abschirmelement (126) einen Signalpfad (128) zum definierten Übertragen eines elektromagnetischen Signals aufweist.

7. Sicherheitsschalter nach einem der Ansprüche 1 bis 6, **dadurch gekennzeichnet, dass** der Transponder (44) in einem weiteren Abschirmelement (46), vorzugsweise in einer einseitig offenen Abschirmbuchse, angeordnet ist.

8. Sicherheitsschalter nach einem der Ansprüche 1 bis 7, **dadurch gekennzeichnet, dass** die Leseeinheit (48) eine Empfangsspule (50) aufweist, die in einem dritten Abschirmelement (122) angeordnet ist.

9. Sicherheitsschalter nach einem der Ansprüche 1 bis 8, **dadurch gekennzeichnet, dass** die Abschirmelemente (46; 56; 102; 122; 126) elektrische leitfähige, nicht-ferromagnetische Abschirmelemente, vorzugsweise aus Aluminium, Kupfer, Silber, Gold oder einer Kombination davon sind.

10. Sicherheitsschalter nach einem der Ansprüche 1 bis 9, **dadurch gekennzeichnet, dass** das Schaltelement (72) im Bereich der Leseeinheit (48) angeordnet ist.

11. Sicherheitsschalter nach einem der Ansprüche 1 bis 10, **gekennzeichnet durch** einen Drucksensor (62), mit dessen Hilfe ein Betätigungsdruck auf dem Stellelement (38) detektierbar ist.

12. Sicherheitsschalter nach einem der Ansprüche 1 bis 11, **dadurch gekennzeichnet, dass** das Stellelement (38) aus einem korrosionsfreien Material hergestellt und/oder staubfrei gekapselt ist.

## Claims

1. A safety switch, particularly an emergency stop switch, for reliably switching off a dangerous device (12), comprising a mechanically operated actuating element (38) moveable between a first position and at least one second position, and comprising a detector element for detecting the actuating element (38) in at least one of the said positions, the detector element comprising a transponder (44) having an individual transponder identification (68) and comprising a reading unit (48) designed for reading out the transponder identification (68), the transponder (44) and the reading unit (48) being arranged relative to one another in such a way that the reading unit (48) is capable of reading out the transponder (44) in the first position of the actuating element (38) but not in its second position, **characterized in that** the safety switch is a mechanically operated safety switch with a switch housing (42), at which the actuating element (38) and in which the detector element, a shielding element (56; 102; 126) for the selective shielding of electromagnetic signals (62) and a switching element (72) are arranged, by means of which switching element the reading out of the transponder identification (68) can be selectively suppressed, the shielding element (56; 102; 126) and the transponder (44) and/or the reading unit (48) being movable relative to one another in dependence on the actuating element (38).

2. The safety switch of claim 1, **characterized in that** the transponder (44) is arranged on the movable actuating element (38).

3. The safety switch of claim 1 or 2, **characterized in that** the shielding element (56) has a clearance, which in the first position of the actuating element (38) lies on a substantially straight connecting line (60) between the transponder (44) and the reading unit (48).

4. The safety switch of anyone of claims 1 to 3, **characterized in that** the shielding element is arranged on the actuating element.

5. The safety switch of anyone of claims 1 to 3, **characterized in that** the shielding element (102) has a portion which runs substantially transversely in relation to a direction of movement (34) of the actuating element (38) and has an opening (104) for the actuating element (38) to pass through.

6. The safety switch of anyone of claims 1 to 3, **characterized in that** the shielding element (126) has a signal path (128) for the defined transmission of an electromagnetic signal.

7. The safety switch of anyone of claims 1 to 6, **characterized in that** the transponder (44) is arranged in a further shielding element (46), preferably in a shielding bush that is open on one side.

8. The safety switch of anyone of claims 1 to 7, **characterized in that** the reading unit (48) has a receiving coil (50), which is arranged in a third shielding element (122).

9. The safety switch of anyone of claims 1 to 8, **characterized in that** the shielding elements (46; 56; 102; 122; 126) are electrically conductive, non-ferromagnetic shielding elements, preferably of aluminum, copper, silver, gold or a combination of these.

10. The safety switch of anyone of claims 1 to 9, **characterized in that** the switching element (72) is arranged in the region of the reading unit (48).

11. The safety switch of anyone of claims 1 to 10, **characterized by** a pressure sensor (62) for detecting an operating pressure on the actuating element (38).

12. The safety switch of anyone of claims 1 to 11, **characterized in that** the actuating element (38) is produced from a non-corroding material and/or is encapsulated in a dust-free manner.

## Revendications

1. Commutateur de sécurité, en particulier disjoncteur de secours, qui débranche en toute sécurité un appareil (12) présentant un risque de danger,
le commutateur de sécurité présentant un élément d'actionnement (38) actionné mécaniquement et apte à être déplacé entre une première et au moins une deuxième position et un élément de détecteur qui détecte l'élément d'actionnement (38) dans au moins l'une desdites positions,
l'élément de détecteur contenant un transpondeur (44) doté d'une identification individuelle (68) de transpondeur et une unité de lecteur (48) configurée pour lire l'identification (68) du transpondeur,
le transpondeur (44) et l'unité de lecture (48) étant disposés l'un par rapport à l'autre de telle sorte que l'unité de lecteur (48) puisse lire le transpondeur (44) dans la première position de l'élément d'actionnement (38) mais non dans sa deuxième position,
**caractérisé en ce que**
le commutateur de sécurité est un commutateur de sécurité actionné mécaniquement et doté d'un boîtier (42) de commutateur sur lequel l'élément d'actionnement (38) et dans lequel l'élément de détecteur, un élément de blindage (56; 102; 126) qui blinde sélectivement les signaux électromagnétiques (62) et un élément de commutation (72) sont disposés,
**en ce que** l'élément de commutation permet d'interdire de manière contrôlée la lecture de la caractéristique (68) du transpondeur et
**en ce que** l'élément de blindage (56; 102; 126) et le transpondeur (44) et/ou l'unité de lecture (48) peuvent être déplacés les uns par rapport aux autres en fonction de l'élément d'actionnement (38).

2. Commutateur de sécurité selon la revendication 1, **caractérisé en ce que** le transpondeur (44) est disposé sur l'élément mobile d'actionnement (38).

3. Commutateur de sécurité selon les revendications 1 ou 2, **caractérisé en ce que** l'élément de blindage (56) présente une découpe qui est située dans la première position de l'élément d'actionnement (38) sur une ligne (60) essentiellement droite qui relie le transpondeur (44) et l'unité de lecture (48).

4. Commutateur de sécurité selon l'une des revendications 1 à 3, **caractérisé en ce que** l'élément de blindage est disposé sur l'élément d'actionnement.

5. Commutateur de sécurité selon l'une des revendications 1 à 3, **caractérisé en ce que** l'élément de blindage (102) présente une partie qui s'étend essentiellement transversalement par rapport à la direction (34) du déplacement de l'élément d'actionnement (38), avec une ouverture (104) permettant la traversée par l'élément d'actionnement (38).

6. Commutateur de sécurité selon l'une des revendications 1 à 3, **caractérisé en ce que** l'élément de blindage (126) présente un parcours de signalisation (128) qui transfère de manière définie un signal électromagnétique.

7. Commutateur de sécurité selon l'une des revendications 1 à 6, **caractérisé en ce que** le transpondeur (44) est disposé dans un autre élément de blindage (46), de préférence dans une douille de blindage ouverte d'un côté.

8. Commutateur de sécurité selon l'une des revendications 1 à 7, **caractérisé en ce que** l'unité de lecture (48) présente une bobine de réception (50) disposée dans un troisième élément de blindage (122).

9. Commutateur de sécurité selon l'une des revendications 1 à 8, **caractérisé en ce que** les éléments de blindage (46; 56; 102; 122; 126) sont des éléments de blindage électriquement conducteurs et non ferromagnétiques, de préférence en aluminium, en cuivre, en argent, en or ou en une de leurs compositions.

10. Commutateur de sécurité selon l'une des revendications 1 à 9, **caractérisé en ce que** l'élément de commutation (72) est disposé au niveau de l'unité de lecture (48).

11. Commutateur de sécurité selon l'une des revendications 1 à 10, **caractérisé par** un détecteur de pression (62) à l'aide duquel une pression d'actionnement exercée sur l'élément d'actionnement (38) peut être détectée.

12. Commutateur de sécurité selon l'une des revendications 1 à 11, **caractérisé en ce que** l'élément d'actionnement (38) est réalisé en un matériau insensible à la corrosion et/ou est protégé de la poussière par une encapsulation.
